**Europäisches Patentamt**

**European Patent Office**

**Office européen des brevets**

(19)

(11) Veröffentlichungsnummer: **0 282 622**
**B1**

(12)

# EUROPÄISCHE PATENTSCHRIFT

(45) Veröffentlichungstag der Patentschrift:
**04.10.89**

(21) Anmeldenummer: **87104122.4**

(22) Anmeldetag: **20.03.87**

(51) Int. Cl.⁴: **H01R 23/70,** H01K 3/28

(54) **Steckverbinder zur direkten Kontaktierung einer Leiterplatte.**

(43) Veröffentlichungstag der Anmeldung:
**21.09.88 Patentblatt 88/38**

(45) Bekanntmachung des Hinweises auf die Patenterteilung:
**04.10.89 Patentblatt 89/40**

(84) Benannte Vertragsstaaten:
**DE GB IT NL SE**

(56) Entgegenhaltungen:
**US-A- 4 095 866**
**US-A- 4 138 711**
**US-A- 4 303 291**

(73) Patentinhaber: **WINCHESTER ELECTRONICS ZWEIGWERK DER LITTON PRECISION PRODUCTS INTERNATIONAL GMBH, Otto-Hahn-Strasse 8, D-7100 Heilbronn(DE)**

(72) Erfinder: **Kniese, Wolfgang, Dipl.-Ing.,
Raubachstrasse 24, D-6927 Bad Rappenau(DE)**
Erfinder: **Schempp, Otto, Dipl.-Ing., Rembachstrasse 23, D-6927 Bad Rappenau(DE)**

(74) Vertreter: **Patentanwälte TER MEER - MÜLLER - STEINMEISTER, Mauerkircherstrasse 45, D-8000 München 80(DE)**

## Beschreibung

Die Erfindung betrifft eine Steckverbinder zur direkten Kontaktierung einer Leiterplatte, die beidseitig mit Leiterbahnen und in Ausrichtung auf Federkontakte in einem Steckergehäuse entlang eine Kante mit durch Einstecken der Leiterplatte in das Steckergehäuse zu kontaktierenden Kontaktanschlüssen belegt ist, und die eine beidseitig mindestens doppelreihige Anordnung von Federkontakten im Steckergehäuse, mit einem ersten im Steckergehäuse weiter innen, d.h. näher zur vertikalen Längsmittelsymmetrieebene des Steckergehäuses stehenden Reihenpaar von kürzeren Federkontakten und einem zweiten im Steckergehäuse weiter außen stehenden Reihenpaar von längeren Federkontakten aufweist, und geht aus von der US-A 4 095 866.

Bei der direkten Dontaktierung einer sogenannten Tochterplatte in einem mit einer Mehrzahl solcher elektronische Bauelemente tragenden Leiterplatten bestückten elektrischen/elektonischen Gerät mit einer Verdrahtungs- oder Backpanel-Platte werden zweireihige Steckverbinder verwendet, wobei bei in das Steckverbindergehäuse eingesteckter Tochterplatte die Federkontakte der eine Reihe des Steckverbinders nebeneinander angeordnete Kontaktanschlüsse auf der einen und die Federkontakte der gegenüberstehenden Reihe Kontaktanschlüsse auf der gegenüberliegenden Seite der Tochterplatte kontaktieren. Aufgrund der ständig fortschreitenden Miniaturisierung der elektronischen Bauelemente und Baugruppen und der Erhöhung der Packungsdichte wären jedoch mehr Anschlüsse über den Steckverbinder wünschenswert, beispielsweise in zwei oder mehreren gestaffelten Reihen hintereinander. Wird in einem solchen Fall jedoch die Tochterkarte aus einem "lebenden", d.h. unter Strom stehenden elektrischen System herausgezogen, so sind Kontaktgaben zwischen den einzelnen Kontaktreihen unvermeidlich, d.h. eine solche Tochterplatte oder Karte könnte nur bei abgeschaltetem System herausgezogen werden.

Der Erfindung liegt damit die Aufgabe zugrunde, eine Anschlußmöglichkeit für mehrere Kontaktreihen auf jeder Seite einer Tochterkarte zu schaffen, die ein Herausziehen oder Auswechseln einer Karte auch bei unter Stom stehenden Systemen ermöglicht, ohne Gefahr zu laufen, daß eine unerwünschte Kontaktgabe eintritt.

Erfindungsgemäß wird eine solche nicht erwünschte Kontaktgabe bei einem Steckverbinder zur direkten Kontaktierung einer Leiterplatte nach der eingangs genannten Art vermieden durch
- mindestens zwei in der jeweiligen Leiterplattenfläche hintereinander angeordnete Reihen von Kontaktanschlüssen auf jeder Seite der Leiterplatte, von denen die Kontakte der näher zur Leiterplattenkante liegenden ersten Reihe auf die Federkontakte des ersten Reihenpaars und die Kontakte der weiter von der Leiterplattenkante weg angeordneten zweiten Reihe auf die Federkontakte des zweiten Reihenpaars ausgerichtet sind, sowie durch
- je eine beidseitig auf die Leiterplatte zwischen den Kontakten der ersten Kontaktreihe aufgebrachte erste Reihe von aus der Leiterplattenfläche vorspringenden Gleit-Heberippen, welche beim Einstecken bzw. Herausziehen der Leiterplatte in das bzw. aus dem Steckergehäuse die längeren Federkontakte des zweiten Federkontakt-Reihenpaars von der Leiterplattenfläche so weit abheben, daß eine Kontaktierung der Kontakte der ersten Kontaktanschlußreihe durch die längeren Federkontakte des zweiten Reihenpaars ausgeschlossen ist.

In bevorzugter Ausführungsform ist vorgesehen, die Tochterkarte mit einem in Längsrichtung der Anschlußkante verlaufenden zusätzlichen Kunststoffteil zu versehen, das nach Art eines doppelreihigen Kamms oder bei drei Federkontaktreihenpaaren im Steckergehäuse nach Art eines doppelreihigen Gitters gestaltet ist, wobei die Kammzinken bzw. die Gitterelemente, die Gleit-Heberippen bilden und die übergreifenden Federkontakte im auf dem Backpanel befestigten Steckergehäuse so lange hochdrücken, d.h. eine Kontaktgabe unmöglich machen, bis die Tochterkarte in der richtigen Position steht. Erst dann erfolgt eine Kontaktierung zu den weiteren im Inneren der Karte liegenden Kontaktanschlüssen ("Landeplätzen") für die zugeordneten übergreifenden Kontaktfedern.

Vorteilhafte Einzelheiten und Ausführungsbeispiele der Efindung werden nachfolgend unter Bezug auf die Zeichnung näher erläutert. Es zeigen:

Fig. 1 in schematischer Darstellung einen Steckverbinder mit einer paarweise doppelreihigen Kontaktfeder- und Kontaktanschlußanordnung gemäß der Erfindung zur direkten Kontaktierung einer Leiterplatte;

Fig. 2A, 2B und 2c in schematischer Schnittansicht bzw. Draufsicht eine doppelreihige und 2C Steckverbinderanordnung zur Erläuterung des Grundgedankens der Erfindung;

Fig. 3 und Fig. 4 eine Steckverbinderanordnung mit zweiseitig jeweils drei Reihen von

Kontaktfedern im Steckergehäuse bzw. drei Reihen von Kontaktanschlüssen auf der Leiterplatte, und

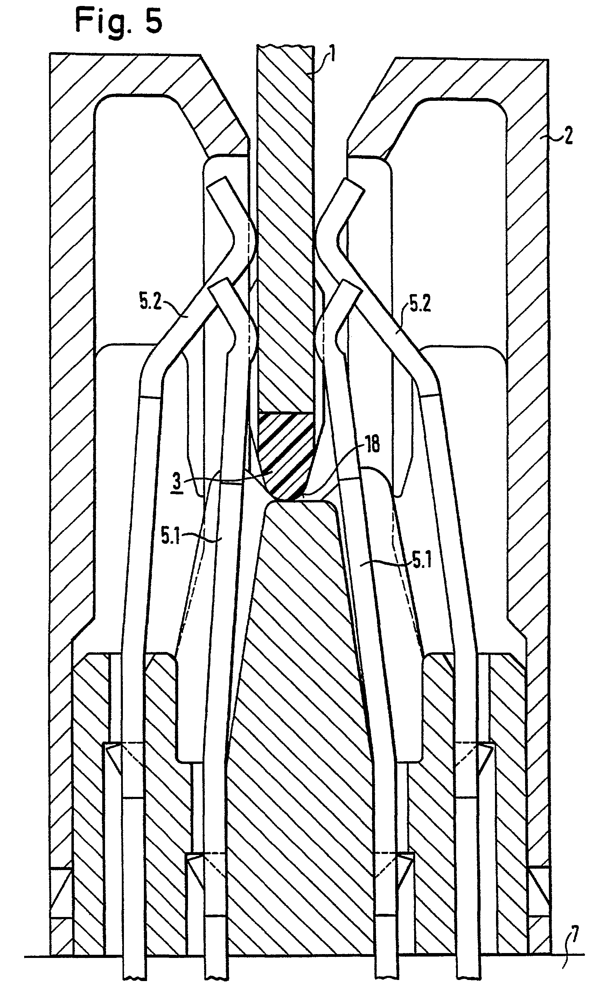

Fig. 5 ein komplettes Ausführungsbeispiel eines Steckverbinders erfindungsgemäßer Art mit zwei Kontaktreihen auf jeder Seite einer Leiterplatte bzw. eines symmetrischen Steckergehäuses.

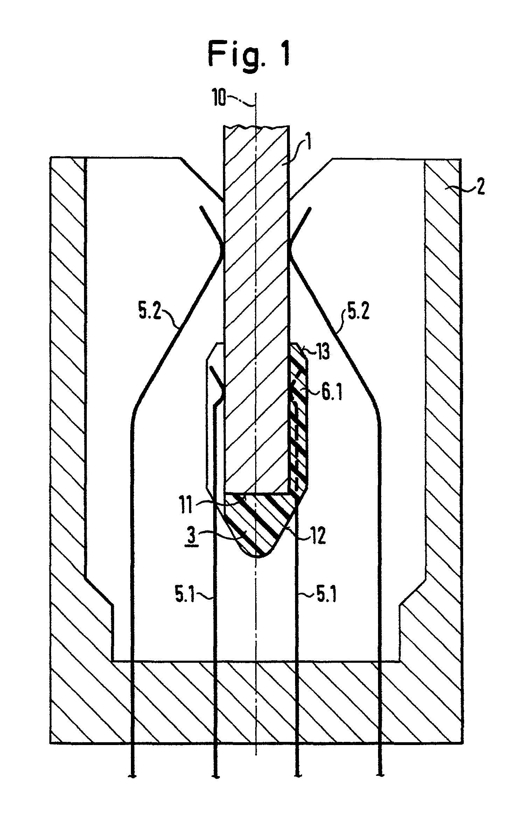

Die schematische Darstellung der Fig. 1 läßt eine Tochterplatte oder Leiterplatte 1 erkennen, die in ein Steckergehäuse 2 eingesetzt ist, das auf einer nicht dargestellten Backpanel-Platte fixiert ist. Im Steckergehäuse 2 sind paarweise Reihen von ersten, kürzeren Kontaktfedern 5.1 in gleichem Abstand zu der zur Zeichenebene senkrecht stehenden vertikalen Längmittelsymmetrieebene (Symmetrieebene 10) eingesetzt, welche den unteren Boden des Steckergehäuses 2 und die (nicht dargestellte) Backpanel-Platte durchsetzen. In entsprechender Weise, jedoch in größerem Abstand von der Symmetrieebene 10 ist ein weiteres Reihenpaar von längeren Kontaktfedern 5.2 vorgesehen, welche die ersten Reihen von Kontaktfedern 5.1 übergreifen. Wie dargestellt, können die Kontaktfedern auf der einen Seite der Leiterplatte 1 auf Lücke zu den Kontaktfedern auf der anderen Seiten der Leiterplatte stehend angeordnet sein.

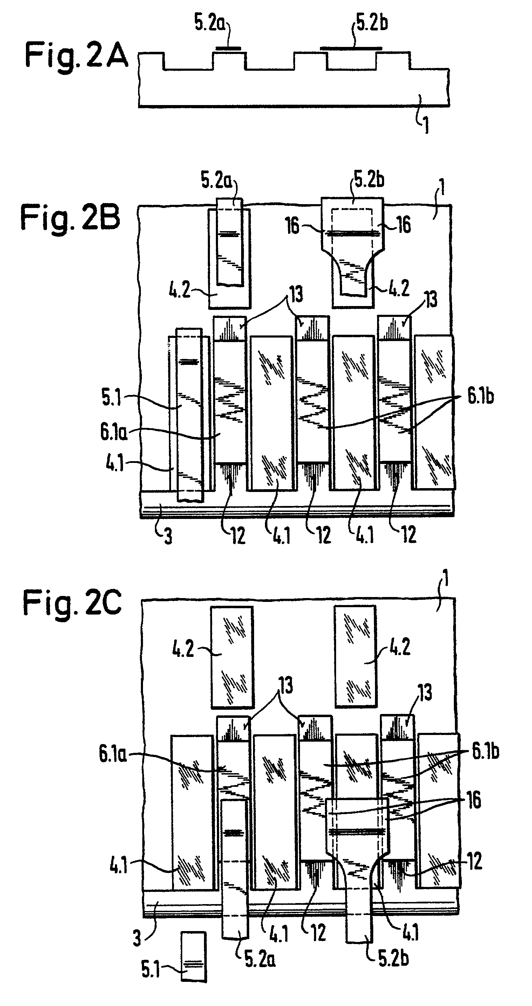

Wie die Figuren 2A, 2B und 2C deutlicher erkennen lassen, sind auf der Leiterplatte 1 auf beiden Oberflächenseiten erste Reihen von Kontaktanschlüssen 4.1 und weiter im Inneren der Leiterplattenfläche liegende zweite Reihen von Kontaktanschlüssen 4.2 ausgebildet. Bie in das Steckergehäuse 2 eingesteckter Leiterplatte 1 werden die Kontaktanschlüssen 4.1 durch die Federkontakte 5.1 kontaktiert von denen in Figur 2B lediglich ein Federkontakt 5.1 dargestellt ist. Die weiter im Inneren der Leiterplatte 1 liegende Reihe von Kontaktanschlüssen 4.2 wird durch die längeren Federkontakte 5.2 kontaktiert, wobei in Figuren 2A, 2B und 2C zwei unterschiedliche Ausführungsformen dargestellt sind, nämlich ein schmälerer Federkontakt 5.2a und ein im Kontaktbereich verbreiterter Federkontakt 5.2b.

Um sicher auszuschließen, daß die übergreifenden längeren Kontaktfedern 5.2 beim Einstecken bzw. Herausziehen der Leiterplatte 1 in Kontaktgabe mit einem Kontaktanschluß 4.1 der ersten weiter zum Rand der Leiterplatte 1 liegenden Reihe der Kontaktanschlüsse gelangt, ist erfindungsgemäß folgende Maßnahme getroffen: Zwischen den Kontaktanschlüssen 4.1 sind aus der Ebene der Leiterplatte 1 vorspringende höckerartige Elemente vorgesehen, die im folgenden als "Gleit-Heberippen" bezeichnet sind in Reihenanordnung nebeneinanderstehen und mit Bezugshinweis 6.1 angegeben sind. Die Gleit-Heberippen 6.1 sind untereinander zu einem kammartigen als einstückiges Kunststoffteil geformten Bauteil durch einen gemeinsamen Kammrücken 3 verbunden. Dieser Kammrücken 3 hält also im Abstand der Dicke der Leiterplatte 1 zwei Reihen von die Gleit-Heberippen 6.1 bildende Kammzähne. Dieser einzige mit Kunststoffteil Rücken 3 und Gleit-Heberippen 6.1 wird auf die Einsteckkante 11 der Leiterplatte 1 so aufgezogen, daß die Gleit-Heberippen 6.1 in den Lücken zwischen den Kontaktanschlüssen 4.1 stehen. Die Gleit-Heberippen 6.1 weisen im Einlaufbereich sowie im Ablaufbereich für die zweite Reihe der Kontaktfedern 5.2 Abschrägungen 12 bzw. 13 auf.

Wird die Leiterkarte 1 in das Steckergehäuse 2 eingesetzt, wobei die Figur 2B eine positionsrichtig und ganz in das Steckergehäuse und Figur 2C eine Zwischenposition ("halb gezogen") der Leiterplatte 1 zeigen, so gleiten die im Steckergehäuse weiter außen stehenden längeren Federkontakte 5.2 über die Abschrägungen 12 auf die Gleit-Heberippen 6.1 und werden dabei abgehoben, so daß eine Kontaktgabe mit den Kontaktanschlüssen 4.1 der ersten Reihe nicht möglich ist (Fig. 2C). Erst wenn die Leiterplatte 1 weiter und vollständig in das Steckergehäuse 2 eingeschoben wird, gleiten die Federkontakte 5.2 über die Abschrägungen 13 wieder in die Ebene der Leiterplatte 1 und gelangen jetzt mit den Kontaktanschlüssen 4.2 der zweiten auf der Leiterplatte 1 weiter innen liegenden Reihe der Kontaktanschlüsse in Kontaktgabe (Fig. 2B). Beim Herausziehen der Leiterplatte 1 aus dem Steckergehäuse 2 werden die Federkontakte 5.2 in der umgekehrten Weise wiederum zunächst abgehoben, und zwar so lange, bis die Leiterplatte 1 praktisch vollständig aus dem Steckergehäuse 2 herausgezogen worden ist, so daß auch in diesem Fall die Gefahr einer unbeabsichtigten Kontaktgabe zu der ersten Reihe der Kontaktanschlüsse 4.1 sicher vermieden ist.

Durch die Erfindung ist es also möglich, eine Leiterplatte 1 in einem "lebenden", d.h. unter Strom stehenden System auszutauschen ohne Gefahr einer unerwünschten Kontaktgabe.

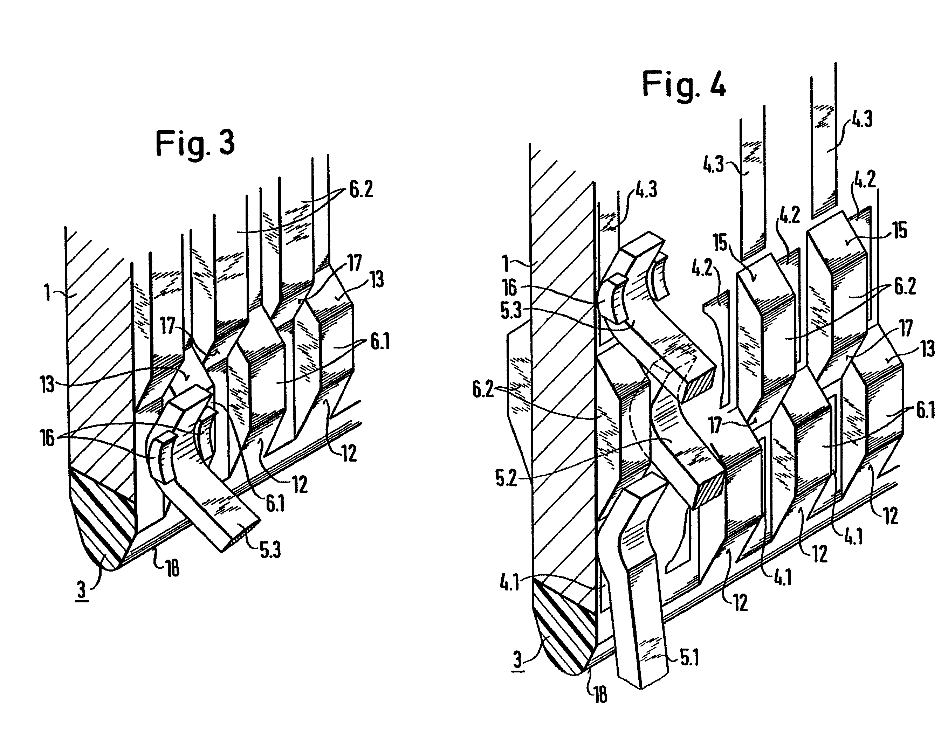

Bei den in Figuren 2A bis 2C dargestellten Ausführungform sind zwei Varianten von Federkontakten 5.2 für die zweiten Federkontaktreihe dargestellt. Bei der weiter links dargestellten Ausführungsform ist die Kontakfeder 5.2a gleichbleibend schmal ausgebildet. Der Federkontaktkopf gleitet beim Einstecken bzw. Herausziehen der Leiterplatte 1 über die ihm zugeordnete eine Gleit-Heberippe 6.1a. Der weiter rechts dargestellte Federkontakt 5.2b dagegen weist im Bereich seines Kontaktkopfes rechts und links verbreiterte Ansätze 16 auf. Beim Einsetzen bzw. Herausziehen der Leiterplatte 1 gleiten die Ansätze 16 über zwei Gleit-Heberippen 6.1b. Auf diese Weise läßt sich eine unerwünschte Kontaktgabe der Federkontakte 5.2 mit den Kontaktanschlüssen 4.1 der ersten Reihe noch sicherer ausschließen. Die Ansätze 16 können einfach durch eine Verbreiterung des Kontaktkopfes der Federkontakte 5.2 oder wie in den Figuren 3 und 4 gezeigt als in einem Stanz-Prägevorgang ausgebildete Ansätze hergestellt sein. Für diesen Fall bei dem die übergreifeden Kontaktfedern 5.2 im Kontaktbereich verbreitert sind, können, da eine Kontaktfeder jeweils auf zwei Gleit-Heberippen gleitet, die Kontaktanschlüsse 4.2 unmittelbar hinter den Kontaktanschlüssen 4.1 angeordnet sein, während bei der erstgenannten Lösung, wie sie in den Figuren 2A bis 2C links veranschaulicht ist, eine versetzte Kontaktanschluß-Reihenanordnung erforderlich ist.

Bei der dritten nachfolgend anhand der Figuren 3 und 4 veranschaulichten Ausführungsform der Erfindung ist bei insgesamt drei Reihenpaaren Von Kontaktanschlüssen 4.1, 4.2 und 4.3 die erste mit der zweiten Lösung kombiniert, das heißt wie sich aus Figur 4 ersehen läßt liegen die Kontaktanschlüsse 4.1 der ersten (in Figur 4 untersten) Reihe in Ausrichtung auf Kontaktanschlüsse 4.3 einer dritten Reihe während die Kontaktanschlüsse 4.2 der zweiten (mittleren) Reihe versetzt zu den beiden erstgenannten Kontaktanschlüssen 4.1 bzw. 4.3 stehen.

Bei dieser für vielpolige Steckverbinder und engen Platzverhältnissen zu bevorzugenden Ausführungsform der Erfindung sind drei Reihenpaare von Federkontakten vorgesehen. Ein erstes Reihenpaar von kurzen Federkontakten 5.1 wird von längeren Federkontakten 5.2 übergriffen und letztere wiederum werden von langen Federkontakten 5.3 übergriffen, die ähnlich wie in Figur 1 dargestellt, in symmetrischer Anordnung hintereinander im Steckergehäuse 2 verankert sind, wobei das Reihenpaar der kürzesten inneren Federkontakte 5.1 der Symmetrieebene 10 am nächsten steht, während das Reihenpaar der (mittleren) übergreifenden Federkontakte 5.2 zwischen den Paarreihen der inneren Federkontakte 5.1 und dem weiteren äußeren Reihenpaar von langen Kontaktfedern 5.3 angeordnet ist.

Wie in den Figuren 3 und 4 gut ersichtlich, sind (entsprechend der oben erwähnten zweiten Lösung) die Kontaktbereiche der Federkontakte 5.3 verbreitert beispielsweise wie daregestellt durch seitliche ohrenartige gestanzte und geprägte Anzätze 16. Auch mit dieser Kontaktfederanordnung mit drei Reihenpaaren von Kontaktfedern 5.1, 5.2 und 5.3 läßt sich ein sicherer Tochterkartenwechsel in einem "lebenden" System gewährleisten, ohne daß es zu unerwünschten Kontaktberührungen kommt und zwar durch folgende Maßnahme:

Ähnlich wie bei der zuerst anhand der Figuren 2A bis 2C beschriebenen Ausführungsform sich zunächst zwischen den Kontaktbereichen 4.1 der ersten (untersten) Reihe Gleit-Heberippen 6.1 vorgesehen mit Auflauf- und Ablaufschrägen 12, 13 wie zuvor beschrieben. Die Kontaktanschlüsse 4.2 der zweiten (mittleren) Reihe stehen - wie erwähnt - auf Lücke zu den Kontaktanschlüssen 4.1 der ersten (untersten) Reihe. Zwischen diesen Kontaktanschlüssen 4.2 der zweiten Reihe sind wiederum im wesentlicen gleichgestaltete Gleit-Heberippen 6.2 vorgesehen, die ebenfalls mit Auflauf- und Ablaufschrägen 17 bzw. 15 versehen sind. In Längsrichtung der zweiten (oberen ) Gruppe von Gleit-Heberippen 6.2 folgen im Anschluß an die Ablaufschrägen 15 die Kontaktanschlüsse 4.3 der dritten (obersten) Reihe, die (wie ebenfalls erwähnt) in Ausrichtung auf die Kontaktanschlüsse 4.,1 der ersten (untersten) Reihe stehen.

Vorteilhafterweise sind die Gleit-Heberippen 6.1 der ersten (unteren) Reihe im Bereich ihrer Seitenflanken mit den Gleit-Heberippen 6.2 der zweiten (oberen) Reihe einstückig verbunden, so daß wiederum die beiden Reihen von Gleit-Heberippen 6.1 bzw. 6.2 zusammen mit einem Rückenteil 3 einstückig als Kunststofformteil ausgebildet sein können. Dieses Kunststofformteil 3, 6.1, 6.2 ist formschlüssig auf die Stirnfläche der Leiterplatte 1 aufgesetzt und weist vorteilhafterweise abgeschrägte oder abgerundete Stirnkanten 18 auf, so daß die Leiterplatte 1 problemlos in die oberseitige Öffnung des Steckergehäuses eingeführt werden kann. Die Gleit-Heberippen 6.1 der untersten Reihe bilden also zusammen mit den auf Lücke stehenden und einstückig verbundenen Gleit-Heberippen 6.2 der zweiten (oberen) Reihe und verbunden über das Rückenteil 3 mit den entsprechenden Gleit-Heberippen auf der gegenüberliegenden Seite der Leiterplatte 1 eine Art doppelreihige Gitteranordnung, die sich als einstückiges Kunststoffspritz- oder Formteil herstellen läßt.

Die Steckverbinderkombination mit paarweise dreireihiger Federkontaktanordnung gemäß der Ausführungsform nach den Figuren 3 und 4 gewährleistet auf folgende Weise ein sicheres Auswechseln der Leiterplatte ohne unerwünschte Kontaktgabe auch bei "lebenden" Systemen wie folgt.

Wird die Leiterplatte 1 in das Steckergehäuse 2 eingeschoben, so gleiten die äußersten übergreifenden langen Federkontakte 5.3 mit ihren den Kontaktkopf verbreiternden Ansätzen 16 über jeweils zwei Gleit-Heberippen 6.1 der untersten Reihe und werden dabei nach außen gedrückt also abgehoben, so daß eine (unerwünschte) Kontaktgabe mit den Kontaktanschlüssen 4.1 der untersten Reihe ausgeschlossen ist. Wird die Leiterplatte 1 weiter in das Steckergehäuse 2 eingeschoben, so kommen bezüglich der längsten übergreifenden Federkontakte 5.3 als nächstes die Gleit-Heberippen 6.2 der zweiten (oberen) Reihe zur Wirkung, die wiederum die Federkontakte 5.3 nach außen gespreizt also abgehoben halten so daß eine (unerwünschte) Kontaktgabe mit den Kontaktanschlüssen 4.2 der zweiten (mittleren) Reihe ebenfalls ausgeschlossen ist. Wird die Leiterplatte 1 schließlich ganz in das Steckergehäuse 2 hineingedrückt, so gleiten die Federkontakte 5.3 über die Schrägflächen 15 und gelangen jetzt in (erwünschten) bestimmungsgemäßen Kontakt mit dem jeweils zugeordneten Kontaktanschlüssen 4.3 der dritten (obersten) Reihe.

Bezüglich der Federkontakte 5.2 des zweiten (mittleren) Reihenpaars von Federkontakten gilt entsprechendes. Diese Federkontakte 5.2 der zweiten Reihe werden beim Eindrücken der Leiterplatte 1 in das Steckergehäuse 2 durch die Gleit-Heberippen 6.1 angehoben, so daß eine unerwünschte Kontaktgabe mit den Kontaktanschlüssen 4.1 der untersten Reihe ausgeschlossen ist. Bei vollständig eingesetzter Leiterplatte 1 kommt dann die erwünschte Kontaktgabe mit den Kontaktanschlüssen 4.2 der zweiten (mittleren) Reihe zustande.

Schließlich kontaktieren die Federkontakte 5.1 der innersten (untersten) Reihe der Federkontakte bei vollständig in das Steckergehäuse 2 eingesetzter Leiterplatte 1 die diesen Federkontakten 5.1 zugeordneten Kontaktanschlüsse 4.1 der ersten (untersten) Reihe.

Eine erfindungsgemäße Steckverbinderkombination zur direkten Kontaktierung einer Leiterplatte zeichnet sich vor allem dadurch aus, daß auf engstem Raum eine Vielzahl von Anschlußverbindungen möglich ist, ohne daß beim Herausziehen bzw. Einschieben der Leiterplatte in den zugeordneten Steckverbinder Fehlkontaktierungen zu befürchten sind, so daß auch ein Leiterplattenwechsel bei unter Strom stehenden Systemen möglich ist.

**Patentansprüche**

1. Steckverbinder zur direkten Kontaktierung einer Leiterplatte (1), die beidseitig mit Leiterbahnen und in Ausrichtung auf Federkontakte (5) in einem Steckergehäuse (2) entlang einer Kante durch Einstecken der Leiterplatte (1) in das Steckergehäuse (2) zu kontaktierenden Kontaktanschlüsse (4) belegt ist, und
- eine beidseitig mindestens doppelreihige Anordnung von Federkontakten (5.1, 5.2, 5.3) im Steckergehäuse (2) mit einem ersten im Steckergehäuse (2) weiter innen, das heißt näher zur vertikalen Längsmittelsymmetrieebene (10) des Steckergehäuses (2) stehenden Reihenpaar von kürzeren Federkontakten (5.1) und einem zweiten im Steckergehäuse (2) weiter außen stehenden Reihenpaar von längeren Federkontakten (5.2) aufweist, gekennzeichnet durch

- mindestens zwei in der jeweiligen Leiterplattenfläche hintereinander angeordnete Reihen von Kontaktanschlüssen (4.1, 4.2) auf jeder Seite der Leiterplatte (1), von denen die Kontakte (4.2) der näher zur Leiterplattenkante liegenden ersten Reihe auf die Federkontakte (5.1) des ersten Reihenpaars und die Kontakte (4.2) der weiter von der Leiterplattenkante weg angeordneten zweiten Reihe auf die Federkontakte (5.2) des zweiten Reihenpaars ausgerichtet sind; und durch
- je eine beidseitig auf die Leiterplatte (1) zwischen den Kontakten (4.1) der ersten Kontaktreihe aufgebrachte erste Reihe von aus der Leiterplattenfläche vorspringenden Gleit-Heberippen (6.1), welche beim Einstecken bzw. Herausziehen der Leiterplatte (1) in das bzw. aus dem Steckergehäuse (2) die längeren Federkontakte (5.2) des zweiten Federkontakt-Reihenpaars von der Leiterplattenfläche so weit abheben, daß eine Kontaktierung der Kontakte (4.1) der ersten Kon-taktanschlußreihe durch die längeren Federkon-takte (5.2) des zweiten Reihenpaars ausgeschlossen ist.

2. Steckverbinder nach Anspruch 1, **gekennzeichnet durch**
- eine beidseitig dreireihige Anordnung von Federkontakten (5.1, 5.2, 5.3) im Steckergehäuse (2), deren drittes Reihenpaar (5.3) im Steckergehäuse (2) von der vertikalen in Längsrichtung des Steckergehäuses verlaufenden Symmetrieebene (10) aus weiter außen steht und längere Federkontakte (5.3) aufweist als die des zweiten Reihenpaars der Federkontakte (5.2);
- eine dritte in der jeweiligen Leiterplattenfläche liegende Reihe von Kontaktanschlüssen (4.3), die auf die Federkontakte (5.3) der dritten Reihe ausgerichtet sind und deren Abstand von der Leiterplattenkante größer ist als der der zweiten Reihe von Kontaktanschlüssen (5.2) und durch
- eine zweite Reihe von Gleit-Heberippen (6.2) auf jeder Plattenseite, welche beim Einstecken bzw. Herausziehen der Leiterplatte (1) in das bzw. aus dem Steckergehäuse (2) die Federkontakte (5.3) des dritten Federkontakt-Reihen-paars von der Leiterplattenebene so weit abhe-ben, daß eine Kontaktierung de Kontaktanschlüsse (4.1 bzw. 4.2) der ersten und der zweiten Reihe ausgeschlossen ist.

3. Steckverbinder nach Anspruch 1 oder 2, **dadurch gekennzeichnet**, daß die Gleit-Heberippen (6.1, 6.2) an den Auf- und Ablaufkanten für die anzuhebenden Kontaktfedern (5.2 bzw. 5.3) abgeschrägt (12, 13; 17, 15) sind.

4. Steckverbinder nach Anspruch 3, **dadurch gekennzeichnet**, daß die Gleit-Heberippen (6.1) der ersten Reihe zwischen den Kontaktanschlüssen (4.1) der ersten Kontaktanschlußreihe angebracht sind.

5. Steckverbinder nach Anspruch 4, **dadurch gekennzeichnet**, daß die Gleit-Heberippen (6.2) der zweiten Reihe zwischen den Kontaktanschlüssen (4.2) der zweiten Kontaktanschlußreihe und auf Lücke zu den Gleit-Heberippen (6.1) der ersten Reihe angeordnet sind.

6. Steckverbinder nach Anspruch 1, **dadurch gekennzichnet**, daß das Reihenpaar der ersten Gleit-Heberippen (6.1) als ein einziges Kunststoffformteil in der Art eines doppelreihigen Kamms gefertigt ist, dessen Kammrücken (3) so auf die Stirnkantenfläche der Leiterplatte (1) aufgesetzt ist, daß eine Reihe der Gleit-Heberippen (6.1) auf der einen und die andere Reihe des Reihenpaars der Gleit-Heberippen (6.1) auf der anderen Oberflächenseite der Leiterplatte (1) anliegt und die Kontakte (4.1) der ersten Kontaktanschlußreihe in Lücken zwischen den ersten Gleit-Heberippen (6.1) liegen.

7. Steckverbinder nach Anspruch 2, **dadurch gekennzeichnet**, daß die beiden Reihenpaare von ersten und zweiten Gleit-Heberippen (6.1, 6.2) als ein einziges Kunststoffformteil in der Art eines doppelreihigen Gitters mit einem die beiden Gitter verbindenden Rückenteile (3) gefertigt und so auf die Stirnkantenfläche der Leiterplatte (1) aufgesetzt sind, daß das Rückenteil die Einlaufkante der Leiterplatte (1) zum Steckergehäuse (2) bildet.

8. Steckverbinder nach Anspruch 6 oder 7, **dadurch gekennzeichnet**, daß die dem Steckergehäuse (2) zugekehrten Kanten des Kammrückens bzw. des Rückenteils (3) abgeschrägt oder abgerundet sind.

9. Steckverbinder nach Anspruch 1, **dadurch gekennzeichnet**, daß die Federkontakte (5.2) des zweiten Reihenpaars von längeren (übergreifenden) Federkontakten in ihrem Kontaktbereich am freien Ende im Vergleich zum übrigen Profilquerschnitt der Federkontakte derart verbreitert sind, daß der Abstand zwischen zwei benachbarten Gleit-Heberippen (6.1) überbrückt ist.

10. Steckverbinder nach Anspruch 2, **dadurch gekennzeichnet**, daß die Federkontakte (5.3) des dritten Reihenpaars von langen (übergreifenden) Federkontakten in ihrem Kontaktbereich am freien Ende im Vergleich zum übrigen Profilquerschnitt der Federkontakte derart verbreitert ist, daß der Abstand zwischen zwei benachbarten Gleit-Heberippen (6.2) der zweiten Reihe von Gleit-Heberippen überbrückt ist.

**Revendications**

1. Connecteur enfichable pour contacter directement une carte à circuit imprimé (1), dont les deux surfaces sont recouvertes de pistes conductrices et de lamelles de contact (4) parallèles à des contacts à ressort (5) installés dans un connecteur femelle (2) situé le long d'un bord, et pouvant être contactées en insérant la carte à circuit imprimé (1) dans le connecteur femelle (2), et
— connecteur femelle (2) dont les deux faces sont pourvues d'un arrangement d'au moins deux rangées de contacts à ressort (5.1, 5.2, 5.3), avec une première paire de rangées de contacts à ressort courts (5.1) située plus près du centre du connecteur femelle (2), c'est-à-dire plus près du plan longitudinal de symétrie vertical (10) du connecteur femelle (2), et une seconde paire de rangées de contacts à ressort longs (5.2) située plus près des bords du connecteur femelle (2), caractérisés en ce que
— au moins deux rangées de lamelles de contact (4.1, 4.2) sont disposées l'une derrière l'autre de chaque côté de la carte à circuit imprimé (1), dont les contacts (4.1) de la première rangée plus proche du bord d'attaque de la carte à circuit imprimé sont parallèles aux contacts à ressort (5.1) de la première paire de rangées et les contacts (4.2) de la seconde rangée, plus éloignée du bord d'attaque de la carte à circuit imprimé, sont parallèles aux contacts à ressort (5.2) de la seconde paire de rangées; et en ce que
– une première rangée de rampes de soulèvement (6.1), en saillie sur la surface de la plaque de circuits imprimés, est disposée sur chaque face de la carte à circuit imprimé (1), entre les contacts (4.1) de la première rangée de contact; ces rampes de soulèvement, lors de l'introduction de la carte à circuit imprimé (1) dans le connecteur femelle (2) ou de son extraction hors de celui-ci, soulèvent les contacts à ressort longs (5.2) de la seconde paire de rangées de contacts à ressort hors du plan de la carte à circuits imprimés (1), de telle sorte que les contacts à ressort longs (5.2) de la seconde paire de rangées ne peuvent pas entrer en contact avec les lamelles de contact (4.1) de la première rangée de lamelles de contact.
2. Connecteur enfichable, selon la revendication 1, caractérisé en ce que
– chaque face du connecteur femelle (2) est pourvue d'un arrangement de trois rangées de contacts à ressort (5.1, 5.2, 5.3), dont la troisième paire de rangées (5.3) se trouve, dans le connecteur femelle (2), plus éloignée du plan longitudinal de symétrie vertical (10) du connecteur femelle (2) et présente des contacts à ressort (5.3) plus longs que l'arrangement de la seconde paire de rangées de contacts à ressort (5.2);
– chaque face de la carte à circuit imprimé est pourvue d'une troisième rangée de lamelles de contact (4.3) qui sont parallèles aux contacts à ressort (5.3) de la troisième rangée et plus éloignées du bord d'attaque de la carte à circuit imprimé que ceux de la seconde rangée de lamelles de contact (5.2), et en ce que
– chaque face de la carte est pourvue d'une seconde rangée de rampes de soulèvement (6.2); ces rampes de soulèvement, lors de l'introduction de la carte à circuit imprimé (1) dans le connecteur femelle (2) ou de son extraction hors de celui-ci, soulèvent les contacts à ressort (5.3) de la troisième paire de rangées de contacts à ressort hors du plan de la carte à circuit imprimé, de telle sorte qu'un contact avec les lamelles de contact (4.1, respectivement 4.2) de la première et de la seconde rangée est exclu.
3. Connecteur enfichable, selon la revendication 1 ou 2, caractérisé en ce que les bords d'attaque et de fuite des rampes de soulèvement (6.1, 6.2) sont biseautées (12, 13; 17, 15), afin de faciliter le passage des contacts à ressort (5.2, respectivement 5.3).
4. Connecteur enfichable, selon la revendication 3, caractérisé en ce que les rampes de soulèvement (6.1) de la première rangée sont disposées entre les lamelles de contact (4.1) de la première rangée de lamelles de contact.
5. Connecteur enfichable, selon la revendication 4, caractérisé en ce que les rampes de soulèvement (6.2) de la seconde rangée sont disposées entre les lamelles de contact (4.2) de la seconde rangée de lamelles de contact, et en quinconce par rapport aux rampes de soulèvement (6.1) de la première rangée.
6. Connecteur enfichable, selon la revendication 1, caractérisé en ce que la paire de rangées des premières rampes de soulèvement (6.1) est fabriquée sous forme d'un peigne unique à deux rangées, moulé plastique, dont la base (3) est disposée sur le bord d'attaque de la carte à circuit imprimé (1) de telle sorte que l'une des rangées de rampes de soulèvement (6.1) repose sur une face de la carte de circuit imprimés (1), tandis que l'autre rangée de rampes de soulèvement (6.1) repose sur l'autre face de la carte de circuit imprimés (1), et que les contacts (4.1) de la première rangée de lamelles de contact sont disposés en quinconce par rapport aux premières rampes de soulèvement (6.1).
7. Connecteur enfichable, selon la revendication 2, caractérisé en ce que les deux paires de rangées des premières et des secondes rampes de soulèvement (6.1, 6.2) se présentent sous forme d'une pièce unique moulée plastique, comprenant deux rangées de grilles et une base (3) reliant les deux grilles, disposée sur le bord avant de la carte à circuit imprimé (1) de telle sorte que la base forme le bord d'attaque de la carte à circuit imprimé (1) par rapport au connecteur femelle (2).
8. Connecteur enfichable, selon la revendication 6 ou 7, caractérisé en ce que les bords de la base du peigne ou de la base de la grille (3), du côté connecteur femelle (2), sont biseautés ou arrondis.
9. Connecteur enfichable, selon la revendication 1, caractérisé en ce que les contacts à ressort (5.2) de la seconde paire de rangées de contacts à ressort longs (qui enjambent les contacts à ressort courts) présentent, à leur extrémité libre, une zone de contact plus large que le reste de la section du profil des contacts à ressort, de telle sorte qu'ils enjambent la distance entre deux rampes de soulèvement (6.1) voisines.
10. Connecteur enfichable selon la revendication 2, caractérisé en ce que les contacts à ressort (5.3) de la trosième paire de rangées de contact à ressort longs (qui enjambent les contacts à ressort courts) présentent, à leur extrémité libre, une zone de contact plus large que le reste de la section du profil des contacts à ressort, de sorte qu'ils enjambent la distance entre deux rampes de soulèvement (6.2) voisines de la seconde rangée de rampes de soulèvement.

**Claims**

1. Plug connector for making direct contact with a circuit board (1) which is covered on both sides with conductor tracks and, in alignment towards spring contacts (5) in a connector shell (2) along one edge, with contact connections (4) with which contact is made by inserting the circuit board (1) into the connector shell (2) and comprising an at least double-rowed arrangement of spring contacts (5.1, 5.2, 5.3) on both sides in the connector shell (2), with a first row pair of shorter spring contacts (5.1) which is located farther on the inside in the connector shell (2), that is to say closer to the vertical longitudinal centre plane of symmetry (10) of the connector shell (2), and a second row pair of longer spring contacts (5.2) which is located farther outside in the connector shell (2); characterized by

- at least two rows of contact connections (4.1, 4.2) which are arranged behind one another on the respective circuit board surface, on each side of the circuit board (1), of which connections the contacts (4.1) of the first row located closer to the circuit board edge are aligned towards the spring contacts (5.1) of the first row pair and the contacts (4.2) of the second row arranged farther away from the circuit board edge are aligned towards the spring contacts (5.2) of the second row pair; and by

- one first row each, applied to the circuit board (1) on both sides between the contacts (4.1) of the first contact row, of sliding/lifting ribs (6.1) which project from the circuit board surface and which, when the circuit board (1) is inserted into or pulled out of the connector shell (2), lift the longer spring contacts (5.2) of the second row pair of spring contacts away from the circuit board surface by such an amount that contact making by the contacts (4.1) of the first row of contact connections with the longer spring contacts (5.2) of the second row pair is rendered impossible.

2. Plug connector according to Claim 1, characterized by

- a three-rowed arrangement of spring contacts (5.1, 5.2, 5.3) on both sides in the connector shell (2), the third row pair (5.3) of which is more on the outside from the vertical plane of symmetry (10) extending in the longitudinal direction of the connector shell in the connector shell (2) and exhibits longer spring contacts (5.3) than those of the second row pair of spring contacts (5.2);

- a third row of contact connections (4.3) which are located on the respective circuit board surface and which are aligned towards the spring contacts (5.3) of the third row and the distance of which from the circuit board edge is greater than that of the second row of contact connections (5.2), and by

- a second row of sliding/lifting ribs (6.2) on each board side, which ribs, when the circuit board (1) is inserted into or pulled out of the connector shell (2), lift off the spring contacts (5.3) of the third row pair of spring contacts from the circuit board plane by such an amount that contact making with the contact connections (4.1 and 4.2, respectively) of the first and second row is rendered impossible.

3. Plug connector according to Claim 1 or 2, characterized in that the sliding/lifting ribs (6.1, 6.2) at the front and rear edges are sloped (12, 13; 17, 15) for the contact springs (5.2 and 5.3, respectively) to be lifted.

4. Plug connector according to Claim 3, characterized in that the sliding/lifting ribs (6.1) are provided in the first row between the contact connections (4.1) of the first row of contact connections.

5. Plug connector according to Claim 4, characterized in that the sliding/lifting ribs (6.2) of the second row are arranged between the contact connections (4.2) of the second row of contact connections and in the gaps between the sliding/lifting ribs (6.1) of the first row.

6. Plug connector according to Claim 1, characterized in that the row pair of the first sliding/lifting ribs (6.1) is fabricated as a single moulded plastic part in a manner of a double-rowed comb, the comb back (3) of which is placed onto the front edge face of the circuit board (1) in such a manner that one row of the sliding/lifting ribs (6.1) rests on one surface side, and the other row of the row pair of sliding/lifting ribs (6.1) rests on the other surface side of the circuit board (1) and the contacts (4.1) of the first row of contact connections are located in the gaps between the first sliding/lifting ribs (6.1).

7. Plug connector according to Claim 2, characterized in that the two row pairs of first and second sliding/lifting ribs (6.1, 6.2) are fabricated as a single moulded plastic part in the manner of a double-rowed grid having a back part (3) which connects the two grids and which are placed onto the front edge face of the circuit board (1) in such a manner that the back part forms the front edge of the circuit board (1) with respect to the connector shell (2).

8. Plug connector according to Claim 6 or 7, characterized in that the edges of the comb back or of the back part (3) facing the connector shell (2) are sloped or rounded.

9. Plug connector according to Claim 1, characterized in that the spring contacts (5.2) of the second row pair of longer (overlapping) spring contacts, in comparison with the other profile cross-section of the spring contacts, are widened in their contact area at the free end, in such a manner that the distance between two adjacent sliding/lifting ribs (6.1) is bridged.

10. Plug connector according to Claim 2, characterized in that the spring contacts (5.3) of the third row pair of long (overlapping) spring contacts, in comparison with the other profile cross-section of the spring contacts, are widened in their contact area at the free end in such a manner that the distance between two adjacent sliding/lifting ribs (6.2) of the second row of sliding/lifting ribs is bridged.

# Fig. 1

Fig. 2A

Fig. 2B

Fig. 2C

Fig. 3

Fig. 4

## Fig. 5